# EUROPEAN PATENT APPLICATION

(11) **EP 2 704 541 A2**
(43) Date of publication of application: **05.03.2014**
(21) Application number: 12193359.2
(22) Date of filing: 20.11.2012
(51) Int. Cl.: H05K 3/24, H05K 3/40, H05K 1/03

(54) **Wiring board, light-emitting device, and method of manufacturing the wiring board**

(30) Priority: 28.08.2012 JP 2012188007
(71) Applicant: Toshiba Lighting & Technology Corporation, Yokosuka-shi Kanagawa 237-8510 (JP)
(72) Inventor: Sasaki, Akihiro, Kanagawa, 237-8510 (JP); Shimokawa, Kazuo, Kanagawa, 237-8510 (JP); Honma, Takuya, Kanagawa, 237-8510 (JP); Betsuda, Nobuhiko, Kanagawa, 237-8510 (JP); Nishimura, Kiyoshi, Kanagawa, 237-8510 (JP)
(74) Representative: Willquist, Sofia Ellinor

(57) **Abstract**

According to one embodiment, a wiring board (1) includes a base (2) assuming a flat plate shape, a wiring pattern (3a) provided in a position on one surface of the base and apart from a peripheral edge of the base, a first metal layer (3b) provided on the opposite side of the base side of the wiring pattern, and a second metal layer (3c) configured to cover the first metal layer and a sidewall (3a1) of the wiring pattern.

## Description

### FIELD

Embodiments described herein relate generally to a wiring board, a light-emitting device, and a method of manufacturing the wiring board.

### BACKGROUND

There is a light-emitting device of a COB (Chip On Board) type in which a light-emitting diode is directly mounted on a board. In the light-emitting device of the COB (Chip On Board) type, for prevention of corrosion of wiring pattern, improvement of bondability in soldering, and the like, wiring pattern and electrodes formed by superimposing a plurality of metal layers are provided on a tabular base. For the formation of the wiring pattern and the electrodes, an electrolytic plating method and an electroless plating method are used. However, if the plurality of metal layers is superimposed using the electrolytic plating method, a sidewall of a lower metal layer is sometimes exposed. If the sidewall of the lower metal layer is exposed, the lower metal layer sometimes corrodes because of oxidation, sulfuration, or the like. It is likely that the reflectance of light made incident on the sidewall is degraded because of the corrosion of the sidewall. On the other hand, if the plurality of metal layers is superimposed using the electroless plating method, a metal layer including a component of a reducing agent included in plating liquid is formed. In this case, an enriching section of the reducing agent component is generated in solder bonding. Therefore, it is likely that the reliability of the solder bonding is degraded.

### BRIEF DESCRIPTION OF THE DRAWINGS

FIGS. 1A to 1D are schematic diagrams for illustrating a light-emitting device including a wiring board according to a first embodiment, wherein FIG. 1A is a perspective view of the light-emitting device, FIG. 1B is a top view in FIG. 1A, FIG. 1C is a bottom view in FIG. 1A, and FIG. 1D is a sectional view in FIG. 1A;
FIGS. 2A to 2C are schematic diagrams for illustrating the wiring board, wherein FIG. 2A is an enlarged sectional view of an A part in FIG. 1D, FIG. 2B is a sectional view illustrating a first metal layer and a fourth metal layer formed by superimposing a plurality of layers, and FIG. 2C is a sectional view illustrating a second metal layer and a fifth metal layer formed by superimposing a plurality of layers;
FIGS. 3A to 3D are schematic process sectional views for illustrating a method of manufacturing a wiring board according to a comparative example; and
FIGS. 4A to 4E are schematic process sectional views for illustrating a method of manufacturing a wiring board according to a second embodiment.

### DETAILED DESCRIPTION

In general, according to one embodiment, a wiring board includes: a base assuming a flat plate shape; a wiring pattern provided in a position on one surface of the base and apart from a peripheral edge of the base; a first metal layer provided on the opposite side of the base side of the wiring pattern; and a second metal layer configured to cover the first metal layer and a sidewall of the wiring pattern.

The second metal layer configured to cover the sidewall, which is an exposed portion of the wiring pattern, is provided in the wiring board. Therefore, it is possible to suppress degradation in the reflectance of light and degradation in light extraction efficiency.

In the wiring board according to the embodiment, the wiring board includes, on the second metal layer, a solder section including at least tin. Activation energy necessary for the material of the first metal layer and the tin to diffuse each other is higher than activation energy necessary for the material of the wiring pattern and the tin to diffuse each other.

In other words, speed at which the material of the first metal layer and the tin diffuse each other is lower than speed at which the material of the wiring pattern and the tin diffuse each other.

With the wiring board, when a light-emitting element is soldered, an alloy layer is formed between the material of the first metal layer and the tin. However, the formed alloy layer is an alloy layer having strength higher than the strength of an alloy layer formed by the material of the wiring pattern and the tin. Further, since the speed at which the material of the first metal layer and the tin diffuse each other is low, it is possible to suppress the thickness dimension of the alloy layer from increasing. Therefore, it is possible to improve reliability of bonding in bonding the light-emitting element.

In the wiring board according to the embodiment, the material of the second metal layer has ionization energy higher than ionization energy of the material of the wiring pattern and the material of the first metal layer.

With the wiring board, it is possible to suppress the sidewall, which is the expose portion of the wiring pattern, from oxidizing or sulfurizing. As a result, it is possible to suppress the wiring pattern from corroding. Therefore, it is possible to suppress degradation in the reflectance of light and degradation in light extraction efficiency.

In the wiring board according to the embodiment, the thickness dimension of the first metal layer is larger than the thickness dimension of the second metal layer.

In the wiring board according to the embodiment, the first metal layer substantially does not include phosphorus.

With the wiring board, it is possible to suppress the concentration of phosphorus from partially increasing when the light-emitting element is soldered. Therefore, it is possible to improve the reliability of bonding in bonding the light-emitting element.

In the wiring board according to the embodiment, the thickness dimension of the first metal layer is equal to or larger than 0.003 mm and equal to or smaller than 0.1 mm.

In the wiring board according to the embodiment, the thickness dimension of the second metal layer is equal to or larger than 0.0001 mm and equal to or smaller than 0.0003 mm.

In the wiring board according to the embodiment, the first metal layer includes at least one of nickel and palladium.

In the wiring board according to the embodiment, the first metal layer includes a plurality of superimposed layers.

The wiring board according to the embodiment further includes: a third metal layer provided on the opposite side of a side of the base where the wiring pattern is provided; a fourth metal layer provided on the opposite side of the base side of the third metal layer; and a fifth metal layer configured to cover the fourth metal layer and a sidewall of the third metal layer.

In the wiring board according to the embodiment, the material of the wiring pattern and the material of the third metal layer are the same, the material of the first metal layer and the material of the fourth metal layer are the same, and the material of the second metal layer and the material of the fifth metal layer are the same.

In the wiring board according to the embodiment, the base is formed of ceramics or composite ceramics of the ceramics and resin.

In general, according to another embodiment, a light-emitting device includes: the wiring board in the embodiment explained above; a light-emitting element provided on the opposite side of a side of the second metal layer where the first metal layer is provided; and a solder section provided between the light-emitting element and the second metal layer.

Since the light-emitting device includes the wiring board explained above, it is possible to realize improvement of light extraction efficiency and realize improvement of reliability concerning bonding of the light-emitting element and the like.

In general, according to still another embodiment, a method of manufacturing a wiring board includes: forming a first seed layer on one surface of a base; forming a first resist mask on the first seed layer; sequentially forming a wiring pattern and a first metal layer in a position in an opening portion of the first resist mask and apart from a peripheral edge of the base; removing the first resist mask and an excess part of the first seed layer; and forming a second metal layer configured to cover the first metal layer and a sidewall of the wiring pattern.

With the method of manufacturing a wiring board, it is possible to prevent a component of a reducing agent from being included in the first metal layer. Therefore, it is possible to suppress an enriching section of the component of the reducing agent (e.g., phosphorus if the first metal layer is nickel) in soldering the light-emitting element. As a result, it is possible to realize improvement of reliability concerning bonding.

Even in a wiring board in which a wiring pattern is not formed to an end of a base, it is possible to cover the sidewall, which is an exposed portion of the wiring pattern, with the second metal layer. Therefore, it is possible to suppress degradation in the reflectance of light and degradation in light extraction efficiency.

In the method in the embodiment, in the forming the first seed layer on the one surface of the base, a second seed layer is further formed on a surface on the opposite side of a side of the base where the first seed layer is formed, in the forming the first resist mask on the first seed layer, a second resist mask is further formed on the second seed layer, in the sequentially forming the wiring pattern and the first metal layer in the position in the opening portion of the first resist mask and apart from the peripheral edge of the base, a third metal layer and a fourth metal layer are further sequentially formed in a position in an opening portion of the second resist mask and apart from the peripheral edge of the base, in the removing the first resist mask and the excess part of the first seed layer, the second resist mask and an excess part of the second seed layer are further removed, and in the forming the second metal layer configured to cover the first metal layer and the sidewall of the wiring pattern, a fifth metal layer configured to cover the fourth metal layer and a sidewall of the third metal layer is further formed.

Embodiments are illustrated with reference to the accompanying drawings. In the drawings, the same components are denoted by the same reference numerals and signs and detailed explanation of the components is omitted as appropriate.

### First Embodiment

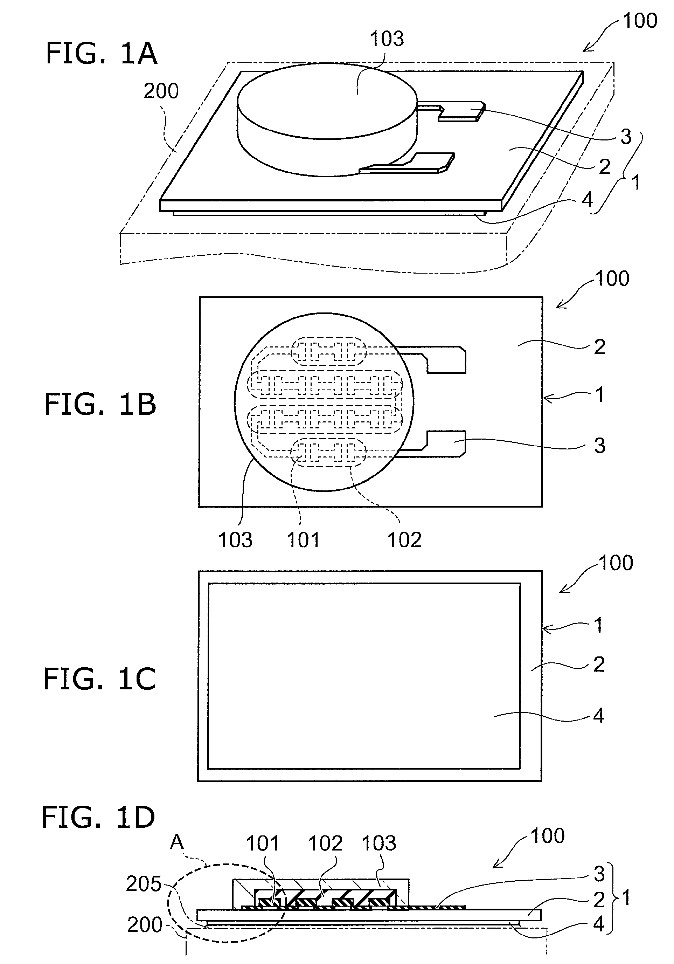

FIGS. 1A to 1D are schematic diagrams for illustrating a light-emitting device 100 including a wiring board 1 according to a first embodiment.

FIG. 1A is a perspective view of the light-emitting device 100, FIG. 1B is a top view in FIG. 1A, FIG. 1C is a bottom view in FIG. 1A, and FIG. 1D is a sectional view in FIG. 1A.

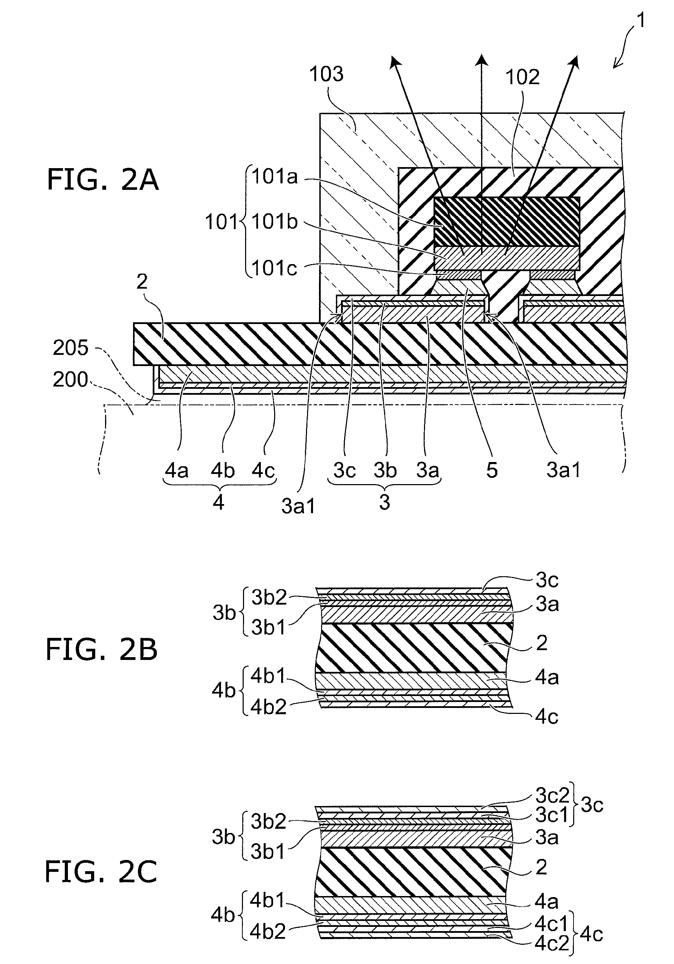

FIGS. 2A to 2C are schematic diagrams for illustrating the wiring board 1.

FIG. 2A is an enlarged sectional view of an A part in FIG. 1D, FIG. 2B is a sectional view illustrating a first metal layer and a fourth metal layer formed by superimposing a plurality of layers, and FIG. 2C is a sectional view illustrating a second metal layer and a fifth metal layer formed by superimposing a plurality of layers.

As shown in FIGS. 1A to 1D, the light-emitting device 100 includes the wiring board 1, a light-emitting element 101, a wavelength converting section 102, and a sealing section 103.

The wiring board 1 includes a base 2, a wiring section 3, and a bonding section 4.

Details concerning the wiring board 1 are explained below.

The light-emitting element 101 is provided on the opposite side of a side of a second metal layer 3c where a first metal layer 3b is provided.

The light-emitting element 101 can be a light-emitting element such as a light-emitting diode, an organic light-emitting diode, or a laser diode.

The light-emitting element 101 can be a blue light-emitting diode that emits blue light.

If the light-emitting element 101 is the blue light-emitting diode, as shown in FIG. 2A, the light-emitting element 101 can be a light-emitting element in which a layer 101b made of a GaN-based nitride semiconductor is formed on a monocrystal board 101a having a high lattice matching property of sapphire or the like.

The light-emitting element 101 is connected to (flip-chip mounted on) the wiring section 3 via a bump (a protrusion) 101c provided on the layer 101b side. However, the light-emitting element 101 does not need to be a flip-chip type and may be a (wire bonding method) type in which a light-emitting layer is formed on an upper surface and an element and a wiring pattern are electrically bonded by a metal wire. In the flip-chip mounted light-emitting element 101, it is possible to reduce a mounting area compared with a light-emitting element connected using the wire bonding method. Further, it is possible to reduce the distance between the light-emitting element 101 and the wiring section 3. Therefore, it is possible to improve electric characteristics.

As shown in FIG. 2A, the layer 101b including the light-emitting layer is provided on the wiring board 1 side. The layer 101b including the light-emitting layer functions as a heat generation source. Therefore, it is easy to allow heat to escape to the wiring board 1 side.

In the case of the light-emitting element connected using the wire bonding method, an electrode for wiring is provided on a light emission side. Therefore, it is likely that light extraction efficiency is degraded. On the other hand, in the flip-chip mounted light-emitting element 101, no obstacle on the light emission side. Therefore, it is possible to improve light extraction efficiency.

The wavelength converting section 102 is provided to cover a plurality of the light-emitting elements 101. The wavelength converting section 102 includes a phosphor excited by primary light emitted from the light-emitting elements 101.

The wavelength converting section 102 can be, for example, a wavelength converting section in which a particulate phosphor is dispersed in an organic matter or an inorganic matter having translucency. Examples of the organic matter having translucency include epoxy resin, silicone resin, methacryl resin (PMMA), polycarbonate (PC), cyclic polyolefin (COP), alicyclic acrylic (OZ), allyl diglycol carbonate (ADC), acrylic resin, fluorine resin, hybrid reins of the silicone resin and the epoxy resin, and urethane resin. Examples of the inorganic matter having translucency include glass.

The organic matter having translucency is desirably resin having thixotropy and Shore hardness after hardening equal to or higher than D40. If the organic matter having translucency is such resin, it is easy to form the wavelength converting section 102 in a desired shape. Further, deformation by external force can be suppressed. Therefore, it is possible to improve reliability concerning connection between the light-emitting element 101 and the wiring section 3. However, the Shore hardness of the resin is not limited to the Shore hardness described above as long as a desired shape and desired characteristics can be secured. Resin having Shore hardness equal to or lower than D40 may be used.

As the material of the wavelength converting section 102, it is desirable to use a resin material in which a linking group of resin is less easily fractured by blue light having high energy. It is possible to suppress coloration due to resin structure breakage during long-time lighting by using such resin. Therefore, it is possible to secure long-term reliability of a light-emitting characteristic. Silicone resin is mainly used as resin having such characteristics. However, since gas permeability is high, the outdoor air permeates into the inside of the wavelength converting section 102 and the light-emitting element 101 covered by the wavelength converting section 102 is degraded. Therefore, it is necessary to impart a resistive structure against gas corrosion to the wavelength converting section 102.

The phosphor included in the wavelength converting section 102 can be, for example, a YAG phosphor (yttrium aluminum garnet phosphor). If the light-emitting element 101 is the blue light-emitting diode and the phosphor included in the wavelength converting section 102 is the YAG phosphor, the YAG phosphor is excited by blue light emitted from the light-emitting element 101. Yellow fluorescence is radiated from the YAG phosphor. The blue light and the yellow light are mixed, whereby white light is emitted from the light-emitting device 100. The phosphor is not limited to the YAG phosphor and can be changed as appropriate according to the use of the light-emitting device 100 such that a desired light-emitting color is obtained.

The sealing section 103 is provided to cover the wavelength converting section 102.

The sealing section 103 is provided in a position apart from a peripheral edge of the base 2. In other words, the sealing section 103 does not reach an end (the peripheral edge) of the base 2.

The sealing section 103 is formed of an organic matter or an inorganic matter having translucency.

The sealing section 103 can be formed of, for example, resin having translucency. Examples of the resin having translucency include epoxy resin, silicone resin, methacryl resin (PMMA), polycarbonate (PC), cyclic polyolefin (COP), alicyclic acrylic (OZ), allyl diglycol carbonate (ADC), acrylic resin, fluorine resin, hybrid resin of the silicone resin and the epoxy resin, and urethane resin.

In this case, a value of a refractive index of the resin forming the sealing section 103 is desirably set to be equal to or smaller than a value of a refractive index of the resin forming the wavelength converting section 102. In other words, a value of a refractive index of the sealing section 103 is desirably equal to or smaller than a value of a refractive index of the wavelength converting section 102.

If the sealing section 103 has such a refractive index, it is possible to suppress light made incident on the sealing section 103 from returning to the wavelength converting section 102. If the value of the refractive index of the resin forming the sealing section 103 and the value of the refractive index of the resin forming the wavelength converting section 102 are set equal, it is possible to suppress reflection on an interface between the sealing section 103 and the wavelength converting section 102. For example, the sealing section 103 and the wavelength converting section 102 can be formed of the same resin. However, the sealing section 103 may be present or absent according to the characteristics of the wavelength converting section 102.

The wiring board 1 is further explained.

The base 2 assumes a rectangular flat plate shape as a plane shape.

The base 2 is desirably formed of a material that has insulation properties and less thermal expansion and is excellent in heat radiation properties and heat resistance properties. The base 2 can be formed of ceramics, composite ceramics of the ceramics and resin, or the like. Examples of the ceramics include aluminum oxide (Al₂O₂), aluminum nitride (AlN), beryllium oxide (BeO), steatite (MgO·SiO₂), zircon (ZrSiO₄), and silicon nitride (Si₃N₄).

The thickness dimension of the base 2 is not specifically limited. However, when rigidity, heat radiation properties, and the like are taken into account, the thickness dimension is desirably set to be, for example, equal to or larger than 0.3 mm and equal to or smaller than 3 mm.

However, the base 2 is not limited to the shape, the material, and the thickness dimension illustrated above and can be changed as appropriate.

As shown in FIG. 1B, the wiring section 3 is provided in a position on one surface of the base 2 and apart from the peripheral edge of the base 2. In other words, the wiring section 3 does not reach the end (the peripheral edge) of the base 2.

As shown in FIG. 2A, the wiring section 3 includes a wiring pattern 3a, the first metal layer 3b, and the second metal layer 3c.

The wiring pattern 3a is provided on the one surface of the base 2. The wiring pattern 3a is provided in a position apart from the peripheral edge of the base 2. The wiring pattern 3a is provided in order to supply electric power to the light-emitting element 101. Therefore, the wiring pattern 3a is formed of a material having electric conductivity. Examples of the material having electric conductivity include copper (Cu). A method of forming the wiring pattern 3a is explained below.

The first metal layer 3b is provided on a surface on the opposite side of the base 2 side of the wiring pattern 3a. The first metal layer 3b is provided to suppress tin (Sn) included in solder and the wiring pattern 3a from forming an alloy when the light-emitting element 101 is soldered. For example, when the light-emitting element 101 is soldered, an alloy (a Cu-Sn alloy) of tin included in solder and copper of the wiring pattern 3a is formed. In this case, a general device does not have to include the first metal layer 3b and may include only copper. However, in particular, in a light source device (a light-emitting device) required to have long-term reliability, growth of a fragile alloy layer (e.g., the Cu-Sn alloy) could be a problem. Therefore, it is desirable to select the material of the first metal layer 3b such that speed at which the material of the first metal layer 3b and the tin disperse each other is lower than speed at which the copper and the tin diffuse each other.

Therefore, the material of the first metal layer 3b is selected such that activation energy necessary for the material of the first metal layer 3b and the tin to diffuse each other is higher than activation energy necessary for the material of the wiring pattern 3a and the tin to diffuse each other. In other words, the material of the first metal layer 3b is selected such that speed at which the material of the first metal layer 3b and the tin disperse each other is lower than speed at which the material of the wiring pattern 3a and the tin disperse each other.

Examples of the material of the first metal layer 3b include nickel (Ni) and palladium (Pd). The first metal layer 3b can be one layer or can be a layer formed by superimposing a plurality of layers. For example, as shown in FIG. 2B, the first metal layer 3b can be formed by superimposing a layer 3b1 and a layer 3b2. The number of superimposed layers is not limited to the illustrated number. If the first metal layer 3b is formed by superimposing a plurality of layers, the first metal layer 3b can include a layer formed of nickel and a layer formed of palladium. In other words, the first metal layer 3b can include at least one of nickel and palladium.

When the first metal layer 3b is formed, a foreign element is sometimes included in the first metal layer 3b depending on a method of forming the first metal layer 3b. Examples of the foreign element include a component of a reducing agent used for electroless plating. For example, as the foreign element, there is phosphorus (P) included in a reducing agent used for electroless nickel plating. If phosphorus is included, the concentration of the phosphorus partially increases when the light-emitting element 101 is soldered. For example, degradation of bonding strength due to an enriching section of the phosphorus occurs. Therefore, it is likely that reliability of bonding in bonding the light-emitting element 101 is degraded. Therefore, a foreign element is substantially not included in the first metal layer 3b as explained below.

The second metal layer 3c is provided to cover the first metal layer 3b and a sidewall 3a1, which is an exposed portion of the wiring pattern 3a.

When the first metal layer 3b oxidizes, problems such as a solder wetting failure in soldering the light-emitting element 101 and creep-up of excess solder due to the solder wetting failure occur. It is likely that a failure such as a leak occurs.

A part of the primary light from the light-emitting element 101 or the fluorescence emitted by the phosphor included in the wavelength converting section 102 is sometimes reflected on a boundary surface between the wavelength converting section 102 and the sealing section 103 and a boundary surface between the sealing section 103 and the outdoor air and made incident on the sidewall 3a1 of the wiring pattern 3a.

In this case, if the sidewall 3a1 of the wiring pattern 3a corrodes, it is likely that the reflectance of the light made incident on the sidewall 3a1 is degraded and light extraction efficiency is degraded.

Therefore, the second metal layer 3c is provided in order to suppress the first metal layer 3b and the sidewall 3a1 of the wiring pattern 3a from corroding.

In order to suppress the first metal layer 3b and the sidewall 3a1 of the wiring pattern 3a from oxidizing, ionization energy of the material of the second metal layer 3c is higher than ionization energy of the material of the first metal layer 3b and ionization energy of the material of the wiring pattern 3a.

Examples of the material of the second metal layer 3c include gold (Au) and palladium.

The second metal layer 3c can be one layer or can be a layer formed by superimposing a plurality of layers. For example, as shown in FIG. 2C, the second metal layer 3c can be formed by superimposing a layer 3c1 and a layer 3c2. The number of superimposed layers is not limited to the illustrated number. If the second metal layer 3c is formed by superimposing a plurality of layers, the second metal layer 3c can include a layer formed of gold and a layer formed of palladium. In other words, the second metal layer 3c can include at least one of gold and palladium.

The solder section 5 is provided between the light-emitting element 101 and the second metal layer 3c.

The solder section 5 can be formed by soldering using solder including, with tin as a base, at least one or more kinds of gold, silver, copper, bismuth, nickel, indium, zinc, antimony, germanium, and silicon.

When the light-emitting element 101 is soldered, the second metal layer 3c located right under the solder section 5 sometimes disappears.

An alloy layer made of the metal included in the solder section 5 and the metal included in the second metal layer 3c is formed between the solder section 5 and the second metal layer 3c.

If the second metal layer 3c located right below the solder section 5 disappears, an alloy layer made of the metal included in the solder section 5 and the metal included in the first metal layer 3b is sometimes formed between the solder section 5 and the first metal layer 3b.

In the bonding of the flip-chip type, a clearance between electrodes is narrow and solder is sometimes extruded from the electrodes. Therefore, a short circuit occurs between the electrodes. If the wiring pattern 3a and the first metal layer 3b are covered with the second metal layer 3c, the solder tends to adhere to the sidewall 3a1 side of the wiring pattern 3a. Therefore, it is possible to suppress the short circuit between the electrodes.

The thickness dimension of the wiring pattern 3a can be set larger than the thickness dimension of the first metal layer 3b. The thickness dimension of the first metal layer 3b can be set larger than the thickness dimension of the second metal layer 3c.

In this case, the thickness dimension of the wiring pattern 3a is desirably set to be equal to or larger than 0.02 mm and equal to or smaller than 0.3 mm when electric conductivity and formation by the electrolytic plating method are taken into account.

A lower limit value of the thickness dimension of the first metal layer 3b can be set to be equal to or larger than a thickness dimension for preventing the first metal layer 3b from disappearing because of diffusion of tin within a range of a requested life of a product. The first metal layer 3b is desirably not formed thicker than necessary from the viewpoint of cost reduction. Therefore, the thickness dimension of the first metal layer 3b is desirably set to be equal to or larger than 0.003 mm and equal to or smaller than 0.1 mm.

The thickness dimension of the second metal layer 3c only has to be set to a thickness dimension enough for surely covering the surface layer of the wiring pattern 3a from the viewpoint of causing the second metal layer 3c to exhibit the functions thereof. Therefore, the thickness dimension of the second metal layer 3c is desirably set to be equal to or larger than 0.0001 mm and equal to or smaller than 0.0003 mm.

The bonding section 4 includes a third metal layer 4a, a fourth metal layer 4b, and a fifth metal layer 4c.

The bonding section 4 is provided to solder the wiring board 1 to another member 200 (e.g., a heat spreader). Therefore, the bonding section 4 is not always necessary and can be provided as appropriate according to necessity.

The third metal layer 4a is provided on the opposite side of a side of the base 2 where the wiring section 3 is provided. The third metal layer 4a is provided in a position apart from the peripheral edge of the base 2. However, the third metal layer 4a is provided to cover the surface of the base 2.

The fourth metal layer 4b is provided on a surface on the opposite side of the base 2 side of the third metal layer 4a. The fourth metal layer 4b is provided in order to suppress tin included in solder 205 and the third metal layer 4a from forming an alloy when the wiring board 1 is soldered to the other member 200.

The fourth metal layer 4b can be one layer or can be a layer formed by superimposing a plurality of layers. For example, as shown in FIG. 2B, the fourth metal layer 4b can be formed by superimposing a layer 4b1 and a layer 4b2. The number of superimposed layers is not limited to the illustrated number.

The fifth metal layer 4c is provided to cover the fourth metal layer 4b and a sidewall 4a1, which is an exposed portion of the third metal layer 4a. As shown in FIG. 2C, the fifth metal layer 4c can be formed by superimposing a layer 4c1 and a layer 4c2. The number of superimposed layers is not limited to the illustrated number. If the fifth metal layer 4c is formed by superimposing a plurality of layers, the fifth metal layer 4c can include a layer formed of gold and a layer formed of palladium. In other words, the fifth metal layer 4c can include at least one of gold and palladium.

The materials and the thickness dimensions of the third metal layer 4a, the fourth metal layer 4b, and the fifth metal layer 4c are not specifically limited. Since the other member 200 is soldered to the bonding section 4, it is necessary to taken into account reliability of bonding and the like as in the bonding of the wiring section 3. If the wiring section 3 and the bonding section 4 can be simultaneously formed, it is possible to realize improvement of productivity.

Therefore, the material and the thickness dimension of the third metal layer 4a can be set the same as the material and the thickness dimension of the wiring pattern 3a.

The material and the thickness dimension of the fourth metal layer 4b can be set the same as the material and the thickness dimension of the first metal layer 3b.

The material and the thickness dimension of the fifth metal layer 4c can be set the same as the material and the thickness dimension of the second metal layer 3c.

Consequently, it is possible to improve reliability of bonding and the like in the bonding section 4 and realize improvement of productivity.

As the solder 205, like the material of the solder section 5, solder including, with tin as a base, at least one or more kinds of gold, silver, copper, bismuth, nickel, indium, zinc, antimony, germanium, and silicon can also be used. Alternatively, solder that can be bonded at lower temperature can also be used.

In the wiring board 1 and the light-emitting device 100 according to this embodiment, the second metal layer 3c that covers the sidewall 3a1, which is the exposed portion of the wiring pattern 3a, is provided. Therefore, it is possible to suppress the sidewall 3a1 from corroding because of oxidation, sulfuration, or the like. As a result, it is possible to suppress degradation of the reflectance of light and degradation of light extraction efficiency.

It is possible to prevent a foreign element, which is a component of a reducing agent, from being substantially included in the first metal layer 3b. Therefore, it is possible to suppress an enriching section of the reducing agent component from being formed when the light-emitting element 101 is soldered. As a result, it is possible to realize improvement of reliability concerning bonding.

The fifth metal layer 4c that covers the sidewall 4a1, which is the exposed portion of the third metal layer 4a, is provided. Therefore, it is possible to suppress the sidewall 4a1 from oxidizing. As a result, it is possible to suppress the third metal layer 4a from corroding. Therefore, it is possible to improve reliability of bonding of the third metal layer 4a and the base 2.

A foreign element, which is a component of a reducing agent, is not substantially included in the fourth metal layer 4b. Therefore, it is possible to suppress an enriching section of the reducing agent component from being formed when the other member 200 is soldered. As a result, it is possible to realize improvement of reliability concerning bonding.

### Second Embodiment

Before a method of manufacturing the wiring board 1 according to a second embodiment is illustrated, a method of manufacturing a wiring board 300 according to a comparative example is explained.

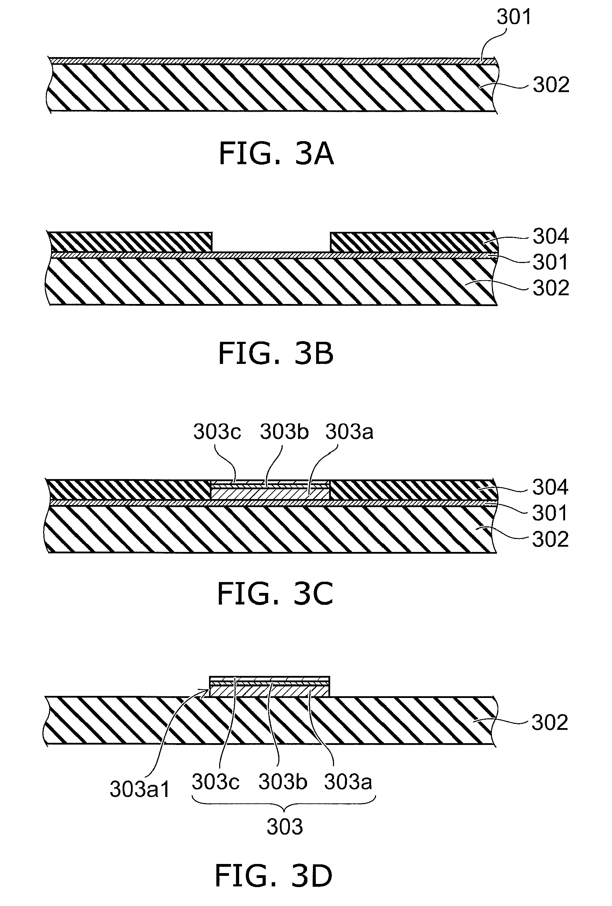

FIGS. 3A to 3D are schematic process sectional views for illustrating the method of manufacturing the wiring board 300 according to the comparative example.

In the method of manufacturing the wiring board 300 according to the comparative example, a wiring section 303 is formed in a position apart from a peripheral end of a base 302 using the electrolytic plating method.

First, as shown in FIG. 3A, a seed layer 301 made of a conductive material is formed on one surface of the base 302.

Subsequently, as shown in FIG. 3B, a resist mask 304 is formed on the seed layer 301.

Subsequently, as shown in FIG. 3C, a wiring pattern 303a, a first metal layer 303b, and a second metal layer 303c are sequentially formed using the electrolytic plating method. In the formation, since the seed layer 301 made of the conductive material reaches the peripheral end of the base 302, it is possible to apply an electric current from the peripheral end of the base 302. Therefore, it is possible to sequentially form the wiring pattern 303a, the first metal layer 303b, and the second metal layer 303c in a position apart from the peripheral end of the base 302.

Subsequently, as shown in FIG. 3D, the resist mask 304 and an excess part of the seed layer 301 are removed. Consequently, it is possible to form the wiring section 303 in the position apart from the peripheral end of the base 302.

However, if the wiring section 303 is formed in the position apart from the peripheral end of the base 302 using the electrolytic plating method, a sidewall 303a1 of the wiring pattern 303a is exposed. As explained above, if the sidewall 303a1 of the wiring pattern 303a is exposed, it is likely that the sidewall 303a1 corrodes and the reflectance of light and light extraction efficiency are degraded.

In this case, the wiring pattern 303a, the first metal layer 303b, and the second metal layer 303c can be sequentially formed in the position apart from the peripheral end of the base 302 using the electroless plating method. Then, the sidewall 303a1 of the wiring pattern 303a can be covered with the first metal layer 303b and the second metal layer 303c.

As explained above, activation energy necessary for the material of the first metal layer 303b and tin to diffuse each other is higher than activation energy necessary for the material of the wiring pattern 303a and tin to diffuse each other. The first metal layer 303b and the tin less easily diffuse each other. For example, the material of the first metal layer 303b is nickel.

If the first metal layer 303b made of nickel is formed using the electroless plating method, hypophosphoric acid (H₃PO₂) is used as the reducing agent. Therefore, phosphorus is included in the first metal layer 303b.

As explained above, if phosphorus is included in the first metal layer 303b, the concentration of the phosphorus sometimes partially increases when the light-emitting element 101 is soldered. Since degradation of bonding strength or the like due to an enriching section of the phosphorus occurs, a new problem occurs in that the reliability of bonding in bonding the light-emitting element 101 is degraded.

Therefore, in the method of manufacturing the wiring board 1 according to the second embodiment, the wiring section 3 is formed by a procedure explained below.

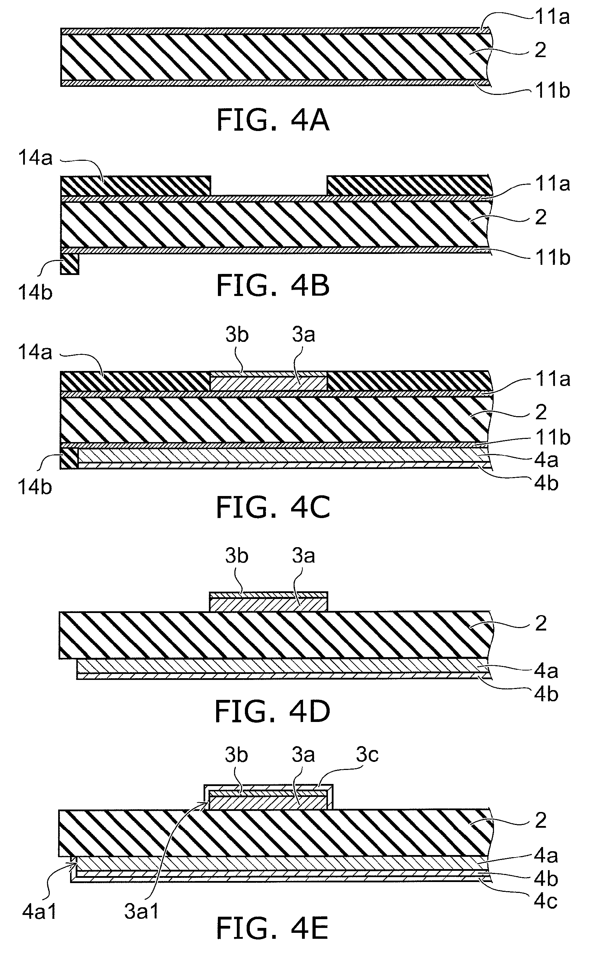

FIGS. 4A to 4E are schematic process sectional views for illustrating the method of manufacturing the wiring board 1 according to the second embodiment.

In the method illustrated in FIGS. 4A to 4E, the wiring section 3 and the bonding section 4 are simultaneously formed.

In the method of manufacturing the wiring board 1 according to the second embodiment, the wiring pattern 3a and the first metal layer 3b are formed in a position apart from the peripheral end of the base 2 using the electrolytic plating method, and the third metal layer 4a and the fourth metal layer 4b are formed in a position apart from the peripheral end of the base 2 using the electrolytic plating method. The second metal layer 3c is formed to cover the wiring pattern 3a and the first metal layer 3b using the electroless plating method, and the fifth metal layer 4c is formed to cover the third metal layer 4a and the fourth metal layer 4b using the electroless plating method.

First, as shown in FIG. 4A, a first seed layer 11a is formed on one surface of the base 2. A second seed layer 11b is formed on the opposite side of a side of the base 2 where the first seed layer 11a is formed.

The first seed layer 11a and the second seed layer 11b are formed to impart electric conductivity to the surface of the base 2 having insulating properties. The conductive material is not specifically limited. However, for example, the conductive material can be a material same as the material of the wiring pattern 3a. The conductive material can be, for example, copper.

The formation of the first seed layer 11a and the second seed layer 11b can be performed using, for example, a sputtering method. The thickness dimension of the first seed layer 11a and the second seed layer 11b can be set to, for example, about 0.00005 mm.

Subsequently, as shown in FIG. 4B, a first resist mask 14a is formed on the first seed layer 11a. A second resist mask 14b is formed on the second seed layer 11b.

The first resist mask 14a is a resist mask for forming the wiring pattern 3a and the first metal layer 3b in a predetermined position of the first seed layer 11a.

The second resist mask 14b is a resist mask 14b for forming the third metal layer 4a and the fourth metal layer 4b in a predetermined position on the second seed layer 11b.

The first resist mask 14a and the second resist mask 14b can be formed by, for example, uniformly applying a liquid resist on the first seed layer 11a and the second seed layer 11b using a spin coater. The first resist mask 14a and the second resist mask 14b can also be formed by, for example, sticking a dry film photoresist with a vacuum crimping machine and using a photolithography method. The thickness dimension of the first resist mask 14a can be set to, for example, a value obtained by adding up the thickness dimension of the wiring pattern 3a and the thickness dimension of the first metal layer 3b.

The thickness dimension of the second resist mask 14b can be set to, for example, a value obtained by adding up the thickness dimension of the third metal layer 4a and the thickness dimension of the fourth metal layer 4b.

Subsequently, as shown in FIG. 4C, the wiring pattern 3a and the first metal layer 3b are sequentially formed in an opening portion of the first resist mask 14a using the electrolytic plating method. Simultaneously with sequentially forming the wiring pattern 3a and the first metal layer 3b, the third metal layer 4a and the fourth metal layer 4b are sequentially formed in an opening portion of the second resist mask 14b. In forming the metal layers, since the first seed layer 11a and the second seed layer 11b made of the conductive material reach the peripheral end of the base 2, it is possible to apply an electric current from the peripheral end of the base 2. Therefore, it is possible to sequentially form the wiring pattern 3a and the first metal layer 3b in a position apart from the peripheral end of the base 2 and form the third metal layer 4a and the fourth metal layer 4b in a position apart from the peripheral end of the base 2.

The material of the wiring pattern 3a and the third metal layer 4a can be, for example, copper.

The material of the first metal layer 3b and the fourth metal layer 4b can be, for example, nickel or palladium.

The thickness dimension of the wiring pattern 3a and the third metal layer 4a can be set to be equal to or larger than 0.02 mm and equal to or smaller than 0.3 mm.

The thickness dimension of the first metal layer 3b and the fourth metal layer 4b can be set to be equal to or larger than 0.003 mm and equal to or smaller than 0.1 mm.

Each of the first metal layer 3b and the fourth metal layer 4b can be one layer or can be a layer formed by superimposing a plurality of layers.

Explanation of plating liquid, process conditions, and the like in the electrolytic plating method is omitted because a known technique can be applied.

Subsequently, as shown in FIG. 4D, the first resist mask 14a, the second resist mask 14b, and excess parts of the first seed layer 11a and the second seed layer 11b are removed.

The removal of the first resist mask 14a and the second resist mask 14b can be performed using, for example, a wet ashing method.

The removal of the excess parts of the first seed layer 11a and the second seed layer 11b can be performed by using, for example, a wet etching method.

Subsequently, as shown in FIG. 4E, the second metal layer 3c is formed to cover the first metal layer 3b and the sidewall 3a1 of the wiring pattern 3a using the electroless plating method. Simultaneously with forming the second metal layer 3c, the fifth metal layer 4c is formed to cover the fourth metal layer 4b and the sidewall 4a1 of the third metal layer 4a.

The material of the second metal layer 3c and the fifth metal layer 4c can be, for example, gold or palladium.

The thickness dimension of the second metal layer 3c and the fifth metal layer 4c only has to be set to thickness enough for surely covering the surface layer of the wiring pattern from the viewpoint of the functions of the second metal layer 3c and the fifth metal layer 4c. For example, the thickness dimension of the second metal layer 3c and the fifth metal layer 4c can be set to be equal to or larger than 0.0001 mm and equal to or smaller than 0.0003 mm.

As shown in FIG. 2C, each of the second metal layer 3c and the fifth metal layer 4c can be one layer or can be a layer formed by superimposing a plurality of layers.

Explanation of plating liquid, process conditions, and the like in the electroless plating method is omitted because a known technique can be applied.

According to the procedure explained above, it is possible to simultaneously form the wiring section 3 and the bonding section 4 in a position apart from the peripheral end of the base 2.

In the method of manufacturing the wiring board 1 according to this embodiment, the wiring pattern 3a and the first metal layer 3b are formed in the position apart from the peripheral end of the base 2 using the electrolytic plating method, and the third metal layer 4a and the fourth metal layer 4b are formed in the position apart from the peripheral end of the base 2 using the electrolytic plating method.

Therefore, it is possible to prevent a foreign element, which is a component of a reducing agent, from being substantially included in the first metal layer 3b. Therefore, it is possible to suppress an enriching section of the reducing agent component from being formed when the light-emitting element 101 is soldered. As a result, it is possible to realize improvement of reliability concerning bonding.

Further, it is possible to prevent a foreign element, which is a component of a reducing agent, from being substantially included in the fourth metal layer 4b. Therefore, it is possible to suppress an enriching section of the reducing agent component from being formed when the other member 200 is soldered. As a result, it is possible to realize improvement of reliability concerning bonding.

The second metal layer 3c is formed to cover the wiring pattern 3a and the first metal layer 3b using the electroless plating method, and the fifth metal layer 4c is formed to cover the third metal layer 4a and the fourth metal layer 4b using the electroless plating method.

Therefore, even in a position apart from the peripheral end of the base 2, since the sidewall 3a1, which is the exposed portion of the wiring pattern 3a, can be covered by the second metal layer 3c, it is possible suppress the sidewall 3a1 from corroding because of oxidation, sulfuration, or the like. As a result, it is possible to suppress degradation of the reflectance of light and degradation of light extraction efficiency.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions. Moreover, above-mentioned embodiments can be combined mutually and can be carried out.

## Claims

1. A wiring board (1) comprising:
a base (2) assuming a flat plate shape;
a wiring pattern (3a) provided in a position on one surface of the base (2) and apart from a peripheral edge of the base (2);
a first metal layer (3b) provided on an opposite side of the base (2) side of the wiring pattern (3a); and
a second metal layer (3c) configured to cover the first metal layer (3b) and a sidewall (3a1) of the wiring pattern (3a).

2. The wiring board (1) according to claim 1, wherein
the wiring board (1) includes, on the second metal layer (3c), a solder section (5) including at least tin, and
activation energy necessary for a material of the first metal layer (3b) and the tin to diffuse each other is higher than activation energy necessary for a material of the wiring pattern (3a) and the tin to diffuse each other.

3. The wiring board (1) according to claim 1 or 2, wherein a material of the second metal layer (3c) has ionization energy higher than ionization energy of a material of the wiring pattern (3a) and a material of the first metal layer (3b).

4. The wiring board (1) according to any one of claims 1 to 3, wherein a thickness dimension of the first metal layer (3b) is larger than a thickness dimension of the second metal layer (3c).

5. The wiring board (1) according to any one of claims 1 to 4, wherein the first metal layer (3b) substantially does not include phosphorus.

6. The wiring board (1) according to any one of claims 1 to 5, wherein a thickness dimension of the first metal layer (3b) is equal to or larger than 0.003 mm and equal to or smaller than 0.1 mm.

7. The wiring board (1) according to any one of claims 1 to 6, wherein a thickness dimension of the second metal layer (3c) is equal to or larger than 0.0001 mm and equal to or smaller than 0.0003 mm.

8. The wiring board (1) according to any one of claims 1 to 7, wherein the first metal layer (3b) includes at least one of nickel and palladium.

9. The wiring board (1) according to any one of claims 1 to 8, wherein the first metal layer (3b) includes a plurality of superimposed layers (3b1, 3b2).

10. The wiring board (1) according to any one of claims 1 to 9, further comprising:
a third metal layer (4a) provided on an opposite side of a side of the base (2) where the wiring pattern (3a) is provided;
a fourth metal layer (4b) provided on an opposite side of the base (2) side of the third metal layer (4a); and
a fifth metal layer (4c) configured to cover the fourth metal layer (4b) and a sidewall (4a1) of the third metal layer (4a).

11. The wiring board (1) according to claim 10, wherein
a material of the wiring pattern (3a) and a material of the third metal layer (4a) are the same,
a material of the first metal layer (3b) and a material of the fourth metal layer (4b) are the same, and
a material of the second metal layer (3c) and a material of the fifth metal layer (4c) are the same.

12. The wiring board (1) according to any one of claims 1 to 11, wherein the base (2) is formed of ceramics or composite ceramics of the ceramics and resin.

13. A light-emitting device(100) comprising:
the wiring board according to any one of claims 1 to 12;
a light-emitting element (101) provided on an opposite side of a side of the second metal layer (3c) where the first metal layer (3b) is provided; and
a solder section (5) provided between the light-emitting element (101) and the second metal layer (3c).

14. A method of manufacturing a wiring board comprising:
forming a first seed layer (11a) on one surface of a base (2);
forming a first resist mask (14a) on the first seed layer (11a);
sequentially forming a wiring pattern (3a) and a first metal layer (3b) in a position in an opening portion of the first resist mask (14a) and apart from a peripheral edge of the base (2);
removing the first resist mask (14a) and an excess part of the first seed layer (11a); and
forming a second metal layer (3c) configured to cover the first metal layer (3b) and a sidewall (3a1) of the wiring pattern (3a).

15. The method of manufacturing a wiring board according to claim 14, wherein
in the forming the first seed layer (11a) on the one surface of the base (2), a second seed layer (11b) is further formed on a surface on an opposite side of a side of the base (2) where the first seed layer (11a) is formed,
in the forming the first resist mask (14a) on the first seed layer (11a), a second resist mask (14b) is further formed on the second seed layer (11b),
in the sequentially forming the wiring pattern (3a) and the first metal layer (3b) in the position in the opening portion of the first resist mask (14a) and apart from the peripheral edge of the base (2), a third metal layer (4a) and a fourth metal layer (4b) are further sequentially formed in a position in an opening portion of the second resist mask (14b) and apart from the peripheral edge of the base (2),
in the removing the first resist mask (14a) and the excess part of the first seed layer (11a), the second resist mask (14b) and an excess part of the second seed layer (11b) are further removed, and
in the forming the second metal layer (3c) configured to cover the first metal layer (3b) and the sidewall (3a1) of the wiring pattern (3a), a fifth metal layer (4c) configured to cover the fourth metal layer (4b) and a sidewall (4a1) of the third metal layer (4a) is further formed.
